# EUROPEAN PATENT APPLICATION

(11) **EP 1 139 403 A1**
(43) Date of publication of application: **04.10.2001**
(21) Application number: 00106567.1
(22) Date of filing: 27.03.2000
(51) Int. Cl.: H01L 21/316, C23C 16/40

(54) **Method for depositing a doped silicon oxide**

(71) Applicant: Infineon Technologies AG, 81669 München (DE); Semiconductor 300 GmbH & Co. KG, 01074 Dresden (DE); MOTOROLA, INC., Schaumburg, IL 60196 (US)
(72) Inventor: Germann, Kai-Uwe, 01326 Dresden (DE); John, Peggy, 01139 Dresden (DE); Vatel, Oliver, 01309 Dresden (DE); Shahvandi, Iraj, 01326 Dresden (DE)
(74) Representative: Epping, Wilhelm, Dipl.-Ing.

(57) **Abstract**

The present invention refers to a method for depositing a silicon oxide with a constant doping profile. Usually there is a higher dopant concentration (3) when the first nanometers of BPSG (Bor Phosphor Silicate Glass) are deposited on a surface (4) of a substrate (1). To avoid this dopant increasement a method for stabilizing the gas flow, gas mixing and dopant concentration by bypassing mixed gases (11,12) outside a reactor (8) is introduced by this invention.

## Description

The present invention refers to a method to deposit a doped silicon oxide.

Doped silicon oxide or so called doped silicate glass is used as an intermetallic dielectric in semiconductor devices for isolating vias and interconnections.

A method and an apparatus for depositing a silicon oxide layer onto a wafer or a substrate is known from the patents US 5,648,175 and EP 0 778 358 A1.

These patents disclose a method where the precursor gases include silicon, oxygen, boron, phosphor and germanium to form a germanium doped BPSG (Boron Phosphor Silicate Glass) layer.

The problem that arises when depositing doped silicon oxides is that the dopant concentration is not constant for the deposited oxide layer. The variation in dopant concentration leads to non-conform etching due to different etch rates for different dopant concentrations in the silicon oxide.

When a doped silicon oxide layer is deposited upon a substrate surface the variation in dopant concentration is very high for the first deposited nanometers. This is due to the non-constant gas mixture ratio for the different precursor gases, which stabilize during the first moments, when the first nanometers of the BPSG are deposited.

It is an object of the invention to provide a method which enables a more constant dopant concentration in deposited silicon oxide layers.

To obtain the above mentioned object, a method for depositing a doped silicon oxide layer is provided comprising:
- locating a substrate in a chemical vapour deposition reactor;
- mixing at least a first gas and a second gas in a gas mixing unit;
- bypassing the mixed first gas and second gas outside the reactor while stabilizing the gas mixture ratio of the first gas and the second gas;
- reducing the pressure in the reactor while bypassing the mixed first and second gases;
- increasing the pressure in the reactor when introducing the stabilized gas mixture ratio into the reactor.

The method according to the invention is to deposit a doped silicon oxide layer stabilizes the gas mixture ratio while not introducing the gas mixture into the reactor. Therefore no reaction takes place in the reactor before the gas mixture ratio has stabilized. When introducing the stabilized gas mixture ratio into the reactor afterwards, the silicon oxide layer is deposited more homogeneously because the gas mixture is already stabilized.

Another method to obtain the above mentioned object comprises:
- locating a substrate in a chemical vapour deposition reactor;
- mixing at least a first gas and a second gas in a gas mixing unit
- bypassing the mixed first gas and second gas outside the reactor while stabilizing the gas mixture ratio of the first gas and the second gas;
- keeping the pressure in the reactor stable while bypassing the gas mixture by introducing an inert gas into the reactor.

This method solves the problem of gas pressure difference in the reactor for the two steps of bypassing the gas mixture and introducing the gas mixture into the reactor. The inert gas which is introduced into the reactor while bypassing the gas mixture keeps the pressure in the reactor stable. When the gas mixture is introduced into the reactor, the inert gas is no longer flowing into the reactor, so that there is no big pressure step when introducing the gas mixture into the reactor.

Another method to obtain the above mentioned object is a method for depositing a doped silicon oxide layer comprising:
- locating a substrate in a chemical vapour deposition reactor; mixing at least a first gas and a second gas in the gas mixing unit;
- bypassing the mixed first gas and second gas outside the reactor while stabilizing the gas mixture ratio of the first gas and the second gas;
- ramping up the introduction of the stabilized gas mixture ratio and dopants into the reactor so that the deposited doped silicon oxide is build up with a uniform dopant concentration.

This method enables the deposition of a doped silicon oxide layer while the first deposited nanometers do not show a dopant increase compared to the dopant concentration in the following deposited silicon oxide layer.

In all the above mentioned methods according to the invention it is an object to provide a more constant dopant concentration in deposited oxide layers. A central problem is to provide a uniform dopant concentration for the first few nanometers of deposited oxide to avoid over etching resulting form subsequent etch processes. The three methods use the same deposition chamber and the same process steps. The difference between the methods is in the way, the gas mixture and other gases is introduced into the reactor, so that the three solutions concern the same invention and represent different examples.

An embodiment of the invention comprises that the substrate is heated to a temperature between 400 to 1250 degrees centigrade. This process step enables a CVD (chemical vapour deposition) process to use several different precursor gases which react at the heated surface of the substrate.

A further embodiment of the invention comprises that the doped silicon oxide comprises arsenic, phosphor or boron. Arsenic, phosphor and boron are typical dopants for the doping of silicon and silicon oxide.

In a preferred embodiment of the invention a plasma is established in the chemical vapour deposition reactor. The plasma enhances the CVD of the doped silicon oxide and can be used to speed up the deposition an improve the gap fill capabilities of the CVD.

An other embodiment of the invention comprises that the CVD deposition is enhanced by a radiation directed to the surface of the substrate. The radiation is enhancing the deposition by improving the deposition rate and can be used to explicitly grow the silicon oxide on the surface of the substrate and not on the side wall of the CVD reactor by directing the radiation onto the surface.

The invention is further explained using examples with reference to figures.

The figures show:
- Figure 1: a substrate with a trench where a BPSG is deposited on the substrate and comprises dopant variations;
- Figure 2: a substrate with a trench and a deposited BPSG layer where the dopant variation and the BPSG layer have been removed;
- Figure 3: an apparatus for depositing a silicon oxide layer onto a wafer or a substrate.

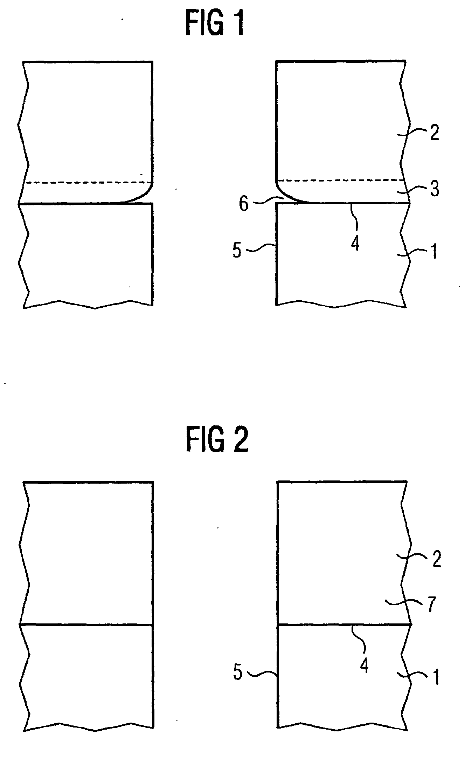

Figure 1 shows a substrate 1 with a doped silicon oxide 2 deposited on a surface 4 of the substrate 1. The doped silicon oxide 2 contains a higher dopant concentration 3 near the surface 4 of the substrate 1. A trench 5 is etched into the doped silicon oxide 2 and the substrate 1. An overetch 6 is located above the surface 4 of the substrate 1 where the dopant concentration 3 is higher than for the rest of the doped silicon oxide 2.

Figure 2 shows the substrate 1 with a doped silicon oxide 2 deposited on top of the surface 4 of the substrate 1. The doped silicon oxide 2 shows a homogeneous doping 7 and a trench 5 is edged into the substrate 1 and a doped silicon oxide 2.

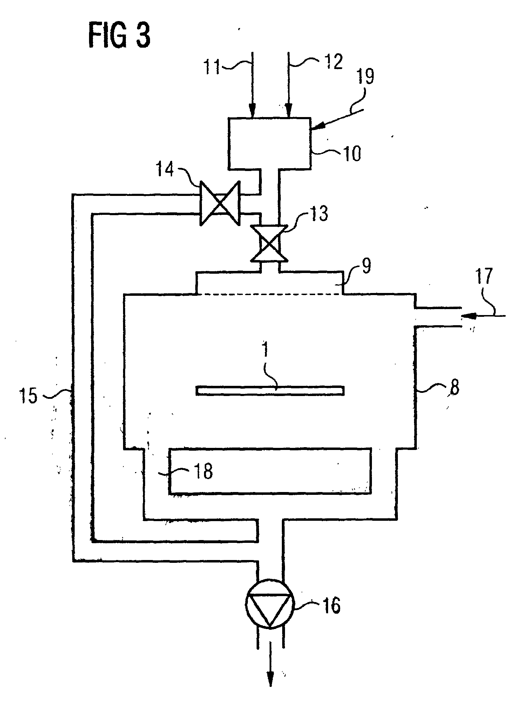

In figure 3 a chemical vapour deposition reactor 8 is shown. Inside the chemical vapour deposition reactor 8 a substrate 1 is localized. Above the substrate 1 a showerhead 9 is arranged to function as a gas introduction for the processing gas. The first gas 11 and the second gas 12 are introduced to a gas mixing unit 10. In the gas mixing unit 10 the first gas and the second gas are mixed and can flow through the first valve 13 into the showerhead and into the reactor 8 or can flow through the second valve 14 into the bypass 15 and be pumped out of the bypass 15 by a pump 16. The pump 16 also pumps the gas flowing through the gas outflow 18 out of the reactor 8. An additional gas inflow 17 is arranged with the chemical vapour deposition reactor 8.

For depositing a doped silicon oxide layer on the substrate 1 a first process gas 11 and a second process gas 12 are introduced into the gas mixing unit 10. At this step the first valve 13 is closed and the second valve 14 is open. As a result the mixed first gas and second gas flow through the bypass 15 into the pump 16 and are pumped out of the system. This process flow can be used to stabilize the gas mixture of the first gas and the second gas. When the gas mixture is stable the second valve 14 is closed and the first valve 13 is opened so that the stabilized gas mixture is flowing into the chemical vapour deposition reactor 8. While the mixed gas is flowing through the bypass 15 the valve 13 is closed. That means that the pressure in the chemical vapour deposition reactor 8 is reduced because the gas is flowing out of the gas outflow 18 to the pump 16. When the first valve is opened, the mixed first gas and second gas flow into the chemical vapour deposition reactor 8 and therefore increase the pressure in the reactor.

To keep the pressure in the reactor 8 stable during the bypass phase an inert gas can be introduced through the additional gas inflow 17 so that the pressure in the reactor 8 is stabilized although the valve 13 is closed. When the gas mixture of the first gas and the second gas flowing through the bypass 15 is stabilized, the first valve 13 is opened to enable the deposition of a silicon oxide layer on the surface of the substrate 1. To keep the pressure in the reactor 8 stable when opening the first valve 13, the gas flow through the additional gas inflow 17 is reduced.

It is also possible to introduce the stabilized gas mixture consisting of the first gas and the second gas into the reactor 8 and ramp up the introduction of dopants into the reactor 8 slower then the ramp up of the gas mixture through the first valve 13. This can be done by changing the dopant concentration inflow 19 to the gas mixing unit 10.

## Claims

1. Method for depositing a doped silicon oxide layer comprising:
- locating a substrate (1) in a chemical vapour deposition reactor (8);
- mixing at least a first (11) and a second gas (12) in a gas mixing unit (10);
- bypassing the mixed first gas (11) and second gas (12) outside the reactor (8) while stabilizing the gas mixture ratio of the first gas (11) and the second gas (12);
- reducing the pressure in the reactor (8) while bypassing the mixed first and second gases (11, 12);
- increasing the pressure in the reactor (8) when introducing the stabilized gas mixture ratio into the reactor (8).

2. Method for depositing a doped silicon oxide layer comprising:
- locating a substrate (1) in a chemical vapour deposition reactor (8);
- mixing at least a first gas (11) and a second gas (12) in a gas mixing unit (10);
- bypassing the mixed first gas (11) and the second gas (12) outside the reactor (8) while stabilizing the gas mixture ratio of the first (11) and the second gas (12);
- keeping the pressure in the reactor (8) stable while bypassing the gas mixture by introducing an inert gas into the reactor.

3. Method for depositing a doped silicon oxide layer comprising:
- locating a substrate (1) in a chemical vapour deposition reactor (8);
- mixing at least a first gas (11) and a second gas (12) in a gas mixing unit (10);
- bypassing the mixed first gas (11) and the second gas (12) outside the reactor (8) while stabilizing the gas mixture ratio of the first gas (11) and the second gas (12);
- ramping up the introduction of the stabilized gas mixture ratio and dopants into the reactor so that the deposited doped silicon oxide (2) is build up with a uniform dopant concentration.

4. Method according to claim 1 to 3,
**characterised in that**
the substrate (1) is heated to a temperature between 400 to 1250 degrees centigrade.

5. Method according to claim 1 to 4,
**characterised in that**
the doped silicon oxide comprises arsenic, phosphor or boron.

6. Method according to claim 1 to 5,
**characterised in that**
a plasma is established in the chemical vapour deposition reactor (8).

7. Method according to claim 1 to 6,
**characterised in that**
the CVD deposition is enhanced by a radiation directed to the surface of the substrate (4).
